# EUROPEAN PATENT APPLICATION

(11) **EP 3 885 849 A1**
(43) Date of publication of application: **29.09.2021**
(21) Application number: 21162388.9
(22) Date of filing: 12.03.2021
(51) Int. Cl.: G05B 13/04, G05B 17/02

(54) **PRIORITIZING EXECUTION OF MULTIPLE GROUPS OF ANALYTIC MODELS**

(30) Priority: 23.03.2020 US 202016826942
(71) Applicant: Baker Hughes Oilfield Operations LLC, Houston, TX 77073 (US)
(72) Inventor: BHARATHI, Shekar, Houston, TX Texas 77073 (US)
(74) Representative: Illingworth-Law, William Illingworth

(57) **Abstract**

A method of prioritization of execution of analytical model sets includes receiving data characterizing a plurality of requests for execution of a plurality of model sets. A first request of the plurality of requests includes a first model set identifier and one or more inputs associated with a first model set of the plurality of model sets. The method also includes determining a plurality of execution times for the plurality of requests. A first execution time of the plurality of execution times is indicative of estimated time of execution of the first model set associated with the first request. Determining the first execution time is based on one or more of historical execution times of the first model set and computational resources utilized in the execution of the first model set.

## Description

### BACKGROUND

An oil and gas production/processing facility (e.g., a refinery) can include assets, which can perform processing and/or delivery of petroleum and natural gas-based resources. These assets can include artificial lift mechanisms (e.g., Electrical Submersible Pumps (ESPs), Rod Lift Systems, etc.) for extracting oil and pipelines for transporting the extracted oil. The assets may fail due to normal wear and tear. Failure of assets can increase risk and can create unsafe conditions, which can ultimately reduce or even halt production and delivery of products. Therefore, it can be desirable to model the operation of these assets using analytical models. The analytical model can predict the operation of the assets based on various inputs (e.g., measurement from sensors coupled to the assets). Based on the predictions, operation of the assets can be improved.

### SUMMARY

Various aspects of the disclosed subject matter may provide one or more of the following capabilities. Prioritization of execution of groups of analytical models can allow for optimal use of system resources. For example, execution of a first set of analytical models can be prioritized over that of a second set of analytical models based on their expected time of execution. Prioritizing can allow for desirable (e.g., optimal) use of system resources and improve user experience and performance.

In one implementation, a prioritization method includes receiving data characterizing a plurality of requests for execution of a plurality of model sets. A first request of the plurality of requests includes a first model set identifier and one or more inputs associated with a first model set of the plurality of model sets. The method also includes determining a plurality of execution times for the plurality of requests. A first execution time of the plurality of execution times is indicative of estimated time of execution of the first model set associated with the first request. Determining the first execution time is based on one or more of historical execution times of the first model set and computational resources utilized in the execution of the first model set. The method further includes executing the first model set based on a first position of the first execution time in a hash map including the plurality of execution times. The plurality of execution times are sorted in the hash map based on their values.

One or more of the following features can be included in any feasible combination.

In one implementation, a second request of the plurality of requests includes a second model set identifier and one or more inputs associated with a second model set of the plurality of model sets. A second execution time of the plurality of execution times is indicative of estimated time of execution of the second model set associated with the second request.

In one implementation, determining the first execution time includes retrieving, from an execution database, historical execution times including execution times associated with a first predetermined number of executions of the first model set in the past and the computational resources associated with the first predetermined number of executions. The retrieving is based on searching the first model set identifier in the execution database. Determining the first execution time also includes calculating a first time average of the execution times associated with the first predetermined number of executions of the first model and a first resource average associated with the computational resources associated with the first predetermined number of executions. Determining the first execution time further includes setting the first execution time to a product of the first time average and the first resource average.

In one implementation, the method further includes determining the second prioritization based on one or more of historical execution times of the second model set and computational resources utilized in the execution of the second model set. In another implementation, the method further includes generating a hash map comprising a first portion configured to store model set identifiers associated with the plurality of model sets, and a second portion configured to store the plurality of execution times. The method also includes saving the first model set identifier and the second model set identifier in the first portion of the hash map, and the first execution time and the second execution time in the second portion of the hash map. The first execution time is mapped to the first model set identifier, and the second execution time is mapped to the second model set identifier. In yet another implementation, the method further includes sorting the hash map based on the values of the first execution time and the second execution time.

In one implementation, the method includes retrieving, from a model deployment database, implementation information associated with the first model set. The implementation information includes one or more of language associated with the first model set, expected inputs of the first model set, expected output of the first model set, computational resources associated with the first model set. The retrieving is based on searching the first model set identifier in the model deployment database. The method also includes executing the first model set based on the retrieved implementation information associated with the first model set.

In one implementation, determining the execution time includes generating a plurality of group task identifiers for the plurality of requests. A first group task identifier of the plurality of group task identifiers is associated with a first request of the plurality of requests. The first group task identifier includes one or more task identifiers indicative of one or more models in the first model. In another implementation, the method further includes providing one or more outputs resulting from the execution of the first model set to the a first monitoring system of a first oil and gas industrial asset. The first request for the execution of the first model set is generated by the first oil and gas industrial asset.

Non-transitory computer program products (i.e., physically embodied computer program products) are also described that store instructions, which when executed by one or more data processors of one or more computing systems, causes at least one data processor to perform operations herein. Similarly, computer systems are also described that may include one or more data processors and memory coupled to the one or more data processors. The memory may temporarily or permanently store instructions that cause at least one processor to perform one or more of the operations described herein. In addition, methods can be implemented by one or more data processors either within a single computing system or distributed among two or more computing systems. Such computing systems can be connected and can exchange data and/or commands or other instructions or the like via one or more connections, including a connection over a network (e.g. the Internet, a wireless wide area network, a local area network, a wide area network, a wired network, or the like), via a direct connection between one or more of the multiple computing systems, etc.

These and other capabilities of the disclosed subject matter will be more fully understood after a review of the following figures, detailed description, and claims.

### BRIEF DESCRIPTION OF THE FIGURES

These and other features will be more readily understood from the following detailed description taken in conjunction with the accompanying drawings, in which:
FIG. 1 is a flow chart of an exemplary method for prioritizing execution of multiple model sets including analytic models;
FIG. 2 illustrates an exemplary computing system configured to prioritize execution of multiple model sets; and
FIG. 3 illustrates an exemplary computing system configured to receive requests for execution of model sets from monitoring systems of oil and gas industrial assets.

### DETAILED DESCRIPTION

Physical systems (e.g., oil and gas industrial systems) can be modeled to assess their current operations and/or predict their future operations. A physical system can be modeled by a set of analytical models (or "model set") that can be executed in parallel or in sequence. The execution of model sets of multiple physical system can be centralized. For example, a given computational system (or a server) or a cluster of computational systems can receive multiple requests to execute model sets of multiple physical systems. This can result in multiple model sets competing for limited computational resources (e.g., memory, processing power, etc.). A high volume of requests and/or long execution times of model sets (e.g., due to increased complexity of the physical system that they represent) can result in a delay of execution of the requests. For example, a queue of requests can be created and the requests are executed on a first come first serve basis. This may be undesirable if a particular request has a higher priority (e.g., needs to be urgently executed), but the particular request is received after another request of lower priority This application provides for systems and methods for prioritizing the requests for execution of model sets of physical systems. The prioritization can be based on, for example, expected execution time of model sets based on previous executions of model sets (e.g., time taken, resource consumed, etc.), expected number of computational resources, etc.

A model set can include multiple models that can model different components of a given physical system. In some implementations, the model set can generate simulation data with predictions on the operation of the physical system. The various model sets can receive sensor data from various components of the physical system as inputs. For example, an oil and gas well can be represented by a model set that includes four analytic models: reservoir model, pipe model, ESP model and a well head model. These models can receive inputs, for example, from sensors coupled to different components of the oil and gas well (e.g., pipes, pumps, well head, etc.), and can be executed sequentially or in parallel. This can allow for identification of the components that are contributing to production loss in the oil and gas well. This can also allow the user to address the loss in production swiftly and efficiently.

Some assessments/predictions can have high priority and may need to be urgently made (e.g., within few minutes from the time a request is made). For example, anomaly detection of pipe thickness may need to be performed as soon as a request for execution of a model set associated with calculation of pipe thickness is received (e.g., after new thickness data has been detected). Alternately, some assessments can have low priority and may not need to be made urgently (e.g., once every few hours or once a day). For example, well production optimization may need to be performed when a production engineer using a web application requests for execution of a model set associated with production optimization. A computational device (e.g., a centralized computational device configured to execute multiple model sets) or a cluster of computational devices can have limited resources (e.g., CPU/GPU, RAM, memory, etc.) and may execute a limited number of requests at any given time duration. It can be desirable to prioritize the execution of model sets associated with a request with higher priority over that of a request with lower priority.

Existing computational systems can execute model sets on a first come first serve basis. This can lead to delayed system triggers that rely on results of simulation of model sets. This can potentially hamper the ability to make swift decisions, and lead to poor user experience. For example, if a request to execute a first model set is made before the request to execute a second model set, the first model set will be executed before the second model set even if the second model set has a higher priority. This may not be desirable. Therefore, a method to prioritize the request for execution of multiple model sets is needed (e.g., based on the estimated time of execution of the model sets).

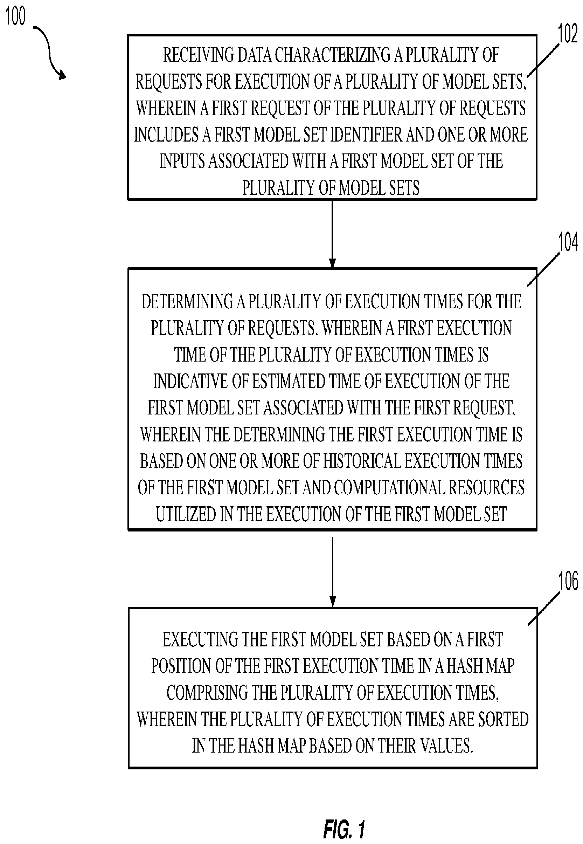

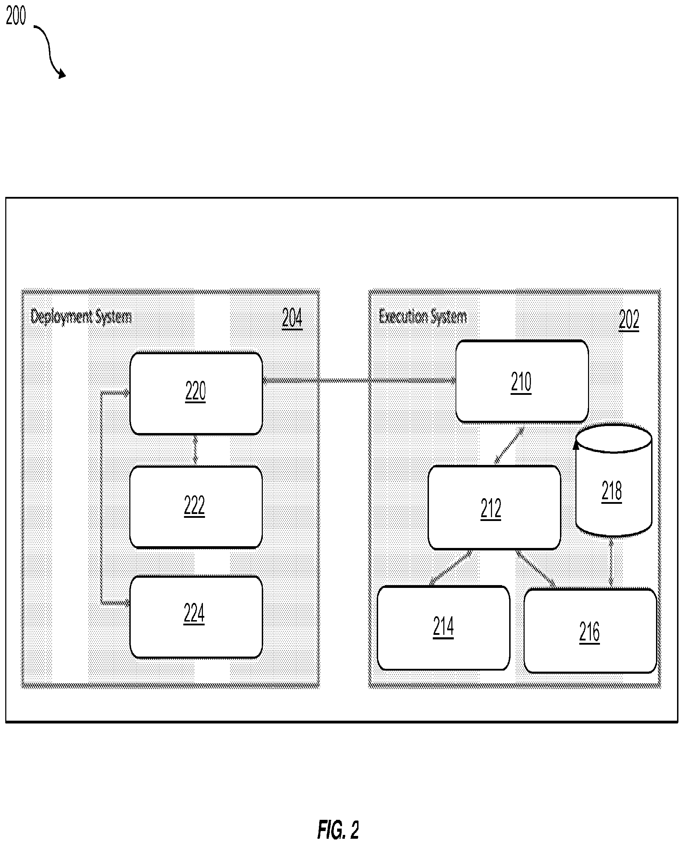

FIG. 1 is a flow chart of an exemplary method for prioritizing execution of multiple model sets. At 102, data characterizing a plurality of requests for execution of a plurality of model sets is received. The plurality of requests can include model set identifiers for identifying the model set corresponding to a given request and various inputs of the model set. For example, a first request of the plurality of requests can include a first model set identifier and one or more inputs associated with a first model set of the plurality of model sets. FIG. 2 illustrates an exemplary computing system 200 that can receive the plurality of requests. The computing system can include an execution system 202 that can prioritize and execute the various model sets, and a deployment system 204 where information associated with the plurality of model sets is stored (e.g., language of the model sets, model set identifiers, execution information, etc.).

At 104, the execution system 202 can receive the plurality of requests and determine a plurality of execution times for executing the plurality of requests. The plurality of execution times can be indicative of the expected time for execution of the received requests. For example, a first execution time of the plurality of execution times can be indicative of estimated time of execution of the first model set (associated with the first request). The determination of the plurality of execution times can be based on historical execution times of the various model sets (e.g., the first model set) and computational resources utilized in the execution of the various model sets (e.g., the first model set). In some implementations, the execution system 202 can also determine the expected resources (e.g., number of processors, Random access memory [RAM], etc.) needed for executing the various requests in the plurality of requests. The expected resources can be determined by calculating an average of historical resources utilized in the execution of the various model sets.

In one implementation, an orchestration execution service 210 of the execution system 202 can receive the plurality of requests. In some implementations, the execution system 202 can generate slots of time or time-bins (e.g., having predetermined time durations). Requests received within a given time-bin can be prioritized based on the expected execution time of the request. After the requests received in the given time-bin are executed, requests received in the next time-bin can be executed. The orchestration execution service 210 can generate an application programming interface (API) through which a request for execution of model sets can be submitted (e.g., by monitoring systems configured to monitor oil wells, pipes, etc.). In order to execute the model sets, the orchestration execution service 210 can request model set information from the deployment system 204.

The deployment system 204 can include orchestration information service 220 that can store, retrieve and modify names of model sets / analytical models in the model sets, model set identifiers (e.g., unique for each model set stored in the deployment system 204), the sequence in which analytical models of a given model set need to be executed, mapping between outputs and inputs of analytical models in a given model set, etc. The deployment system 204 can also include model meta information service 222 that can store, retrieve and modify information about analytic models included in the model sets, the method to initiate execution of the analytical models, the language of the analytical model (e.g., python, java, etc.), the inputs needed by the analytic model, the output from the analytical models, memory address in a database (e.g., executions results store 218) where results from previous model execution are stored, etc. The deployment system 204 can also include model deployment information service 224 that can store, retrieve and modify information about resources required for executing a model set and/or analytical models in the model set (e.g., number of cores [CPU vs GPU], RAM, storage, etc.).

After the orchestration execution service 210 has retrieved model set information (e.g., from the deployment system 204) associated with the received request (e.g., at step 102), it can provide the retrieved model set information and the inputs of the model set (e.g., included in the request) to a distributed task queue 212. This can be repeated for multiple requests (e.g. requests received within a predetermined time slot). In some implementations, for each request, the distributed task queue 212 can generate a group task identifier. A group task identifier can include one or more task identifiers indicative of one or more models in the model set associated with a received request. For example, a first group task identifier can be generated for the first model set (associated with the first request), and the first group task identifier can include one or more task identifiers associated with the analytical models in the first model set. Group task identifiers can be sent to and archived by the orchestration execution service 210 that can map each group task identifier to the corresponding model set identifier.

The retrieved model set information, the inputs of the model set and the group task identifier can be transferred from the distributed task queue 212 to the orchestration prioritization service 216. For a given group task identifier (or model set identifier) associated with a given request (e.g., first request, second request, etc.), the orchestration prioritization service 216 can retrieve historical information for the model set associated with the given group task identifier. For example, the orchestration prioritization service 216 can perform a search in the executions results store 218 based on the model set identifier and/or group task identifier (e.g., for the first and/or second model set).

In some implementations, the historical information for a given model set (e.g., first model set, second model set, etc.) can include execution times associated with previous executions of the given model set, and computational resources used in the previous executions. In some implementations, the orchestration prioritization service 216 can retrieve information associated with a predetermined number of historical executions of the given model set (e.g., last 100 executions). In some implementations, the orchestration prioritization service 216 can retrieve information for all the historical executions that were successfully completed (e.g., has a status identifier indicating successful completion). The executions results store 218 can return information associated with the predetermined number of historical execution and/or successful executions to the orchestration prioritization service 216 for the given group task identifier (e.g., associated with the first model set, second model set, etc.).

The orchestration prioritization service 216 can calculate an expected execution time for the given request based on the retrieved information on historical executions (for the model set associated with the given request) from the executions results store 218. The executions results store 218 can include the start time and end time of historical executions, status of the historical executions (e.g., complete, incomplete, successful, unsuccessful, etc.), inputs of the model sets, output of the model sets, etc. In some implementations, an average of historical execution times for the given model set can be calculated (e.g., for the predetermined number of historical executions). Additionally, an average of historical execution resources (e.g., computation cores) utilized in the historical executions of the model set associated with the given request can be calculated. The expected execution time can be determined by multiplying the average of historical execution times with the average of historical execution resources. For example, if two model sets have the same average of historical execution times, but the first model of the two model sets has consumed fewer resources (e.g., has a smaller average of historical execution resources), the first model set will have a lower expected execution time compared to the second model of the two model sets.

In some implementations, the orchestration prioritization service 216 can calculate the expected execution time for a given request by multiplying the average of historical execution times for the given model set with the number of inputs to the given model set (e.g., received at step 102) and dividing the product by the average number of inputs to the given model set in previous executions of the given model set. For example, a model set (associated with the given request) can require a first execution time when a first number of inputs are provided to the model set. If the number of inputs to the model set is doubled, the corresponding execution time can be twice the first execution time. The retrieved information associated with the predetermined number of historical executions of the given model set can include the number of inputs for the each of the historical executions. The orchestration prioritization service 216 can calculate the average of the number of inputs of the historical executions of the given model set. The aforementioned calculation of expected execution time can be performed for the various requests received by the orchestration service 210. The orchestration prioritization service 216 can generate a hash map where the expected execution times for the various requests of execution of model sets, the associated model set identifiers and/or the associated group task identifiers can be saved (or stored). The hash map can be a table where the expected execution times are stored in a first column and the corresponding group task identifiers are stored in a second column. For example, a first/second expected execution time for a first / second model set can be stored in the first column and the corresponding first / second group task identifiers can be stored in the second column of the table. The first (or second) execution time can be mapped to the first (or second) group task identifier in the hash map.

A hash map created for the plurality of requests received at step 102, can include the expected execution times and the group task identifiers for the various requests in the plurality of requests. The expected execution times in the hash map can be sorted based on the value of the expected execution times (e.g., in an ascending order, descending order, etc.). In one implementation, expected execution times can be arranged in ascending order with respect to the values of the expected execution times. As a result, the position of the expected execution time in the sorted hash map can determine when the corresponding model set will be executed.

Returning to FIG. 1, at 106, model sets (e.g., whose execution requests are received at step 102) can be executed in a temporal order based on the sorted hash map. For example, the model sets can be executed in an ascending order of the corresponding expected execution time. In other words, the model set with the shortest expected execution time will be executed first and the model set with the largest expected execution time will be executed last. The execution of the model sets can be performed by the distributed task queue 212 that can receive the sorted hash map from the orchestration prioritization service 216. The distributed task queue 212 can identify the retrieved model set information for a given model set associated with a given expected execution time in the hash map. This can be done, for example, based on the group task identifier that can be mapped to both the given expected execution time and the corresponding retrieved model set information. The retrieved model set information and the inputs of the given model set can be sent to the model execution service 214 that can execute the given model set. The model execution service 214 can send the output (or outputs) of the given model set to the distributed task queue 212. As the model sets are executed (e.g., based on ascending order of their expected execution times), the outputs from the execution of the model sets can be returned to the orchestration execution service 210 by the distributed task queue 212. The orchestration execution service 210 can return the outputs of a model set to the entity (e.g., a monitoring system of an asset) that made the request for the execution the model set.

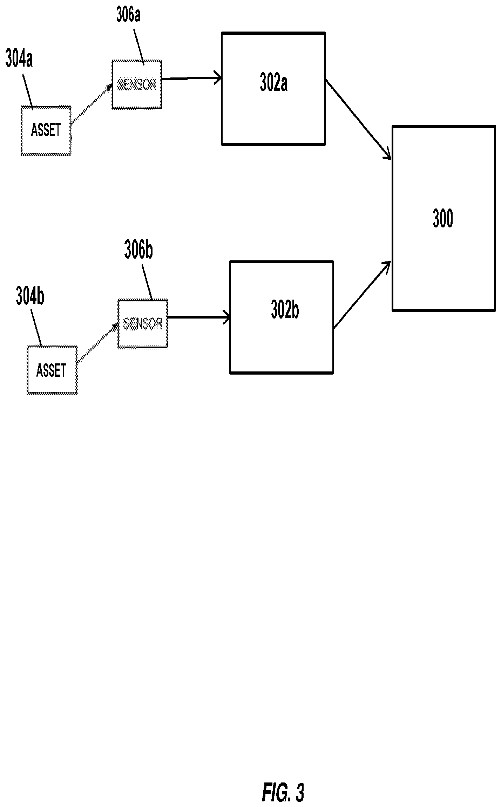

FIG. 3 illustrates an exemplary computing system 300 configured to receive requests for execution of model sets from monitoring systems 302a and 302b. The monitoring systems 302a and 302b is configured to monitor the operations of assets 304a and 304b, respectively. The monitoring system 302a can send a first request to the computing system 300 to execute a first model set associated with the asset 304a. Information associated with the model set of the asset 304a can be stored in the computing system 300 (e.g., in a deployment system in the computing system 300). The request can include inputs for the first model set (e.g., based on measurement by the sensor 306a coupled to the asset 304a). Similarly, a second request to execute a second model set can be sent to the computing system 300 by the monitoring system 302b configured to monitor the asset 304b. The second request can include inputs for the second model set (e.g., based on measurement by the sensor 306b coupled to the asset 304b). The computing system 300 can receive the first and the second requests (e.g., within a predetermined time duration) and determine the request that should be executed first (e.g., based on the exemplary method described in FIG. 1). The computing system 300 can provide the results of the execution of the first and second model sets to the first monitoring system 302a and second monitoring system 302b, respectively, in the order of priority determined by the computing system 300.

Some implementations of the current subject matter can provide many technical advantages. Prioritization of execution of model sets can improve the experience of the users providing requests for model set execution to a computation device. For example, a request with a small expected time of execution can be prioritized and the associated user may not have to wait for a long time (e.g., compared to a first come first serve execution of requests). The current subject matter can also allow for tracking the performance (e.g., time taken, resource consumed, etc.) of the model sets (or analytical models in the model sets). This can provide the users of the model sets with valuable information, for example, in determining the performance of the model sets based on the number of inputs provided to the model set.

Other embodiments are within the scope and spirit of the disclosed subject matter. For example, the prioritization method described in this application can be used in facilities that have complex machines with multiple operational parameters that need to be altered to change the performance of the machines. Usage of the word "optimize" / "optimizing" in this application can imply "improve" / "improving."

Certain exemplary embodiments will now be described to provide an overall understanding of the principles of the structure, function, manufacture, and use of the systems, devices, and methods disclosed herein. One or more examples of these embodiments are illustrated in the accompanying drawings. Those skilled in the art will understand that the systems, devices, and methods specifically described herein and illustrated in the accompanying drawings are non-limiting exemplary embodiments and that the scope of the present invention is defined solely by the claims. The features illustrated or described in connection with one exemplary embodiment may be combined with the features of other embodiments. Such modifications and variations are intended to be included within the scope of the present invention. Further, in the present disclosure, like-named components of the embodiments generally have similar features, and thus within a particular embodiment each feature of each like-named component is not necessarily fully elaborated upon.

The subject matter described herein can be implemented in digital electronic circuitry, or in computer software, firmware, or hardware, including the structural means disclosed in this specification and structural equivalents thereof, or in combinations of them. The subject matter described herein can be implemented as one or more computer program products, such as one or more computer programs tangibly embodied in an information carrier (e.g., in a machine-readable storage device), or embodied in a propagated signal, for execution by, or to control the operation of, data processing apparatus (e.g., a programmable processor, a computer, or multiple computers). A computer program (also known as a program, software, software application, or code) can be written in any form of programming language, including compiled or interpreted languages, and it can be deployed in any form, including as a stand-alone program or as a module, component, subroutine, or other unit suitable for use in a computing environment. A computer program does not necessarily correspond to a file. A program can be stored in a portion of a file that holds other programs or data, in a single file dedicated to the program in question, or in multiple coordinated files (e.g., files that store one or more modules, sub-programs, or portions of code). A computer program can be deployed to be executed on one computer or on multiple computers at one site or distributed across multiple sites and interconnected by a communication network.

The processes and logic flows described in this specification, including the method steps of the subject matter described herein, can be performed by one or more programmable processors executing one or more computer programs to perform functions of the subject matter described herein by operating on input data and generating output. The processes and logic flows can also be performed by, and apparatus of the subject matter described herein can be implemented as, special purpose logic circuitry, e.g., an FPGA (field programmable gate array) or an ASIC (application-specific integrated circuit).

Processors suitable for the execution of a computer program include, by way of example, both general and special purpose microprocessors, and any one or more processor of any kind of digital computer. Generally, a processor will receive instructions and data from a Read-Only Memory or a Random Access Memory or both. The essential elements of a computer are a processor for executing instructions and one or more memory devices for storing instructions and data. Generally, a computer will also include, or be operatively coupled to receive data from or transfer data to, or both, one or more mass storage devices for storing data, e.g., magnetic, magneto-optical disks, or optical disks. Information carriers suitable for embodying computer program instructions and data include all forms of non-volatile memory, including by way of example semiconductor memory devices, (e.g., EPROM, EEPROM, and flash memory devices); magnetic disks, (e.g., internal hard disks or removable disks); magneto-optical disks; and optical disks (e.g., CD and DVD disks). The processor and the memory can be supplemented by, or incorporated in, special purpose logic circuitry.

To provide for interaction with a user, the subject matter described herein can be implemented on a computer having a display device, e.g., a CRT (cathode ray tube) or LCD (liquid crystal display) monitor, for displaying information to the user and a keyboard and a pointing device, (e.g., a mouse or a trackball), by which the user can provide input to the computer. Other kinds of devices can be used to provide for interaction with a user as well. For example, feedback provided to the user can be any form of sensory feedback, (e.g., visual feedback, auditory feedback, or tactile feedback), and input from the user can be received in any form, including acoustic, speech, or tactile input.

The techniques described herein can be implemented using one or more modules. As used herein, the term "module" refers to computing software, firmware, hardware, and/or various combinations thereof. At a minimum, however, modules are not to be interpreted as software that is not implemented on hardware, firmware, or recorded on a non-transitory processor readable recordable storage medium (i.e., modules are not software *per se*)*.* Indeed "module" is to be interpreted to always include at least some physical, non-transitory hardware such as a part of a processor or computer. Two different modules can share the same physical hardware (e.g., two different modules can use the same processor and network interface). The modules described herein can be combined, integrated, separated, and/or duplicated to support various applications. Also, a function described herein as being performed at a particular module can be performed at one or more other modules and/or by one or more other devices instead of or in addition to the function performed at the particular module. Further, the modules can be implemented across multiple devices and/or other components local or remote to one another. Additionally, the modules can be moved from one device and added to another device, and/or can be included in both devices.

The subject matter described herein can be implemented in a computing system that includes a back-end component (e.g., a data server), a middleware component (e.g., an application server), or a front-end component (e.g., a client computer having a graphical user interface or a web interface through which a user can interact with an implementation of the subject matter described herein), or any combination of such back-end, middleware, and front-end components. The components of the system can be interconnected by any form or medium of digital data communication, e.g., a communication network. Examples of communication networks include a local area network ("LAN") and a wide area network ("WAN"), e.g., the Internet.

Approximating language, as used herein throughout the specification and claims, may be applied to modify any quantitative representation that could permissibly vary without resulting in a change in the basic function to which it is related. Accordingly, a value modified by a term or terms, such as "about" and "substantially," are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise.

## Claims

1. A method comprising:
receiving data characterizing a plurality of requests for execution of a plurality of model sets, wherein a first request of the plurality of requests includes a first model set identifier and one or more inputs associated with a first model set of the plurality of model sets;
determining a plurality of execution times for the plurality of requests, wherein a first execution time of the plurality of execution times is indicative of estimated time of execution of the first model set associated with the first request,
wherein determining the first execution time is based on one or more of historical execution times of the first model set and computational resources utilized in the execution of the first model set; and
executing the first model set based on a first position of the first execution time in a hash map comprising the plurality of execution times, wherein the plurality of execution times are sorted in the hash map based on their values.

2. The method of claim 1, wherein a second request of the plurality of requests includes a second model set identifier and one or more inputs associated with a second model set of the plurality of model sets, and
wherein a second execution time of the plurality of execution times is indicative of estimated time of execution of the second model set associated with the second request.

3. The method of claim 2, wherein determining the first execution time includes:
retrieving, from an execution database, historical execution times including execution times associated with a first predetermined number of executions of the first model set in the past and the computational resources associated with the first predetermined number of executions, the retrieving based on searching the first model set identifier in the execution database;
calculating a first time average of the execution times associated with the first predetermined number of executions of the first model and a first resource average associated with the computational resources associated with the first predetermined number of executions; and
setting the first execution time to a product of the first time average and the first resource average.

4. The method of claim 3, further comprising determining the second prioritization based on one or more of historical execution times of the second model set and computational resources utilized in the execution of the second model set.

5. The method of claim 4, further comprising:
generating a hash map comprising a first portion configured to store model set identifiers associated with the plurality of model sets, and a second portion configured to store the plurality of execution times; and
saving the first model set identifier and the second model set identifier in the first portion of the hash map, and the first execution time and the second execution time in the second portion of the hash map, wherein the first execution time is mapped to the first model set identifier, and the second execution time is mapped to the second model set identifier.

6. The method of claim 5, further comprising sorting the hash map based on the values of the first execution time and the second execution time.

7. The method of claim 5, further comprising:
retrieving, from a model deployment database, implementation information associated with the first model set, the implementation information includes one or more of language associated with the first model set, expected inputs of the first model set, expected output of the first model set, computational resources associated with the first model set; the retrieving based on searching the first model set identifier in the model deployment database; and
executing the first model set based on the retrieved implementation information associated with the first model set.

8. The method of claim 7, wherein determining the execution time includes:
generating a plurality of group task identifiers for the plurality of requests, wherein a first group task identifier of the plurality of group task identifiers is associated with a first request of the plurality of requests, wherein the first group task identifier includes one or more task identifiers indicative of one or more models in the first model.

9. The method of claim 1, further comprising providing one or more outputs resulting from the execution of the first model set to the a first monitoring system of a first oil and gas industrial asset, wherein the first request for the execution of the first model set is generated by the first oil and gas industrial asset.

10. A system comprising:
at least one data processor;
memory coupled to the at least one data processor, the memory storing instructions to cause the at least one data processor to perform operations comprising:
receiving data characterizing a plurality of requests for execution of a plurality of model sets, wherein a first request of the plurality of requests includes a first model set identifier and one or more inputs associated with a first model set of the plurality of model sets;
determining a plurality of execution times for the plurality of requests, wherein a first execution time of the plurality of execution times is indicative of estimated time of execution of the first model set associated with the first request,
wherein determining the first execution time is based on one or more of historical execution times of the first model set and computational resources utilized in the execution of the first model set; and
executing the first model set based on a first position of the first execution time in a hash map comprising the plurality of execution times, wherein the plurality of execution times are sorted in the hash map based on their values.

11. The system of claim 10, wherein the a second request of the plurality of requests includes a second model set identifier and one or more inputs associated with a second model set of the plurality of model sets, and
wherein a second execution time of the plurality of execution times is indicative of estimated time of execution of the second model set associated with the second request.

12. The system of claim 11, wherein determining the first execution time includes:
retrieving, from an execution database, historical execution times including execution times associated with a first predetermined number of executions of the first model set in the past and the computational resources associated with the first predetermined number of executions, the retrieving based on searching the first model set identifier in the execution database;
calculating a first time average of the execution times associated with the first predetermined number of executions of the first model and a first resource average associated with the computational resources associated with the first predetermined number of executions; and
setting the first execution time to a product of the first time average and the first resource average.

13. The system of claim 12, wherein the operations further comprising determining the second prioritization based on one or more of historical execution times of the second model set and computational resources utilized in the execution of the second model set.

14. The system of claim 13, wherein the operations further comprising:
generating a hash map comprising a first portion configured to store model set identifiers associated with the plurality of model sets, and a second portion configured to store the plurality of execution times; and
saving the first model set identifier and the second model set identifier in the first portion of the hash map, and the first execution time and the second execution time in the second portion of the hash map, wherein the first execution time is mapped to the first model set identifier, and the second execution time is mapped to the second model set identifier.

15. The system of claim 14, wherein the operations further comprising sorting the hash map based on the values of the first execution time and the second execution time.

16. The system of claim 14, wherein the operations further comprising:
retrieving, from a model deployment database, implementation information associated with the first model set, the implementation information includes one or more of language associated with the first model set, expected inputs of the first model set, expected output of the first model set, computational resources associated with the first model set; the retrieving based on searching the first model set identifier in the model deployment database; and
executing the first model set based on the retrieved implementation information associated with the first model set.

17. The system of claim 16, wherein determining the execution time includes:
generating a plurality of group task identifiers for the plurality of requests, wherein a first group task identifier of the plurality of group task identifiers is associated with a first request of the plurality of requests, wherein the first group task identifier includes one or more task identifiers indicative of one or more models in the first model.

18. The system of claim 10, wherein the operations further comprising providing one or more outputs resulting from the execution of the first model set to the a first monitoring system of a first oil and gas industrial asset, wherein the first request for the execution of the first model set is generated by the first oil and gas industrial asset.

19. A computer program product comprising a machine-readable medium storing instructions that, when executed by at least one programmable processor, cause the at least one programmable processor to perform operations comprising:
receiving data characterizing a plurality of requests for execution of a plurality of model sets, wherein a first request of the plurality of requests includes a first model set identifier and one or more inputs associated with a first model set of the plurality of model sets;
determining a plurality of execution times for the plurality of requests, wherein a first execution time of the plurality of execution times is indicative of estimated time of execution of the first model set associated with the first request,
wherein determining the first execution time is based on one or more of historical execution times of the first model set and computational resources utilized in the execution of the first model set; and
executing the first model set based on a first position of the first execution time in a hash map comprising the plurality of execution times, wherein the plurality of execution times are sorted in the hash map based on their values.

20. The computer program product of claim 19, wherein a second request of the plurality of requests includes a second model set identifier and one or more inputs associated with a second model set of the plurality of model sets, and
wherein a second execution time of the plurality of execution times is indicative of estimated time of execution of the second model set associated with the second request.
